# EUROPEAN PATENT APPLICATION

(11) **EP 1 848 033 A2**
(43) Date of publication of application: **24.10.2007**
(21) Application number: 07105228.6
(22) Date of filing: 29.03.2007
(51) Int. Cl.: H01L 21/8238, H01L 27/092

(54) **Semiconductor Device and Fabrication Method Therefor**

(30) Priority: 20.04.2006 JP 2006116591
(71) Applicant: MATSUSHITA ELECTRIC INDUSTRIAL CO., LTD, Kadoma-shi, Osaka 571-8501 (JP); INTERUNIVERSITAIR MICROELEKTRONICA CENTRUM VZW, 3001 Leuven (BE)
(72) Inventor: Yamamoto, Kazuhiko c/o Matsushita Electric Industrial Co., Ltd, Chuo-ku Osaka-shi Osaka Osaka 540-6319 (JP); Fujimoto, Hiromasa c/o Matsushita Electric Industrial Co., Ltd, Chuo-ku Osaka-shi Osaka Osaka 540-6319 (JP); Kotani, Takafumi c/o Matsushita Electric Industrial Co., Ltd, Chuo-ku Osaka-shi Osaka Osaka 540-6319 (JP)
(74) Representative: Zimmer, Franz-Josef

(57) **Abstract**

A semiconductor device has a transistor of a first conductivity type formed on a semiconductor substrate and having a first gate insulating film and a first gate electrode and a transistor of a second conductivity type having a second gate insulating film and a second gate electrode. The first gate electrode is a metal gate electrode having a metal film and the second gate electrode is a fully-silicided gate electrode made of a silicide film.

## Description

### CROSS REFERENCE TO RELATED APPLICATIONS

The teachings of Japanese Patent Application JP 2006-116591, filed April 20, 2006, are entirely incorporated herein by reference, inclusive of the claims, specification, and drawings.

### BACKGROUND OF THE INVENTION

The present invention relates to a semiconductor device and a fabrication method therefor and, more particularly, to a semiconductor device comprising an n-channel MOS transistor and a p-channel MOS transistor and a fabrication method therefor.

With the recent demand for higher-integrated and higher-speed semiconductor devices, the miniaturization of metal-oxide-film semiconductor field-effect transistors (MOSFETs) has been increasingly promoted. However, when a gate insulating film is thinned for the miniaturization of a MOSFET, the problem of an increase in gate leakage current due to a tunnel current or the like has become conspicuous. To suppress the problem, the use of a high dielectric constant material made of a metal oxide such as hafnium dioxide (HfO₂) or zirconium dioxide (ZrO₂ for the gate insulating film has been attempted. The use of the high dielectric constant material for the gate insulating film allows a reduction in leakage current even when the electrically effective thickness of the gate insulating film is reduced to a value lower than that of a gate insulating film made of silicon dioxide (SiO₂).

For a higher operating speed, on the other hand, it is necessary to reduce the resistance of a gate electrode. For this purpose, a method which performs partial silicidation of a gate electrode made of polysilicon has been used. However, when the polysilicon electrode and the gate insulating film made of a high dielectric constant material are used in combination, the leakage current cannot be sufficiently suppressed. One conceivable reason that the leakage current cannot be sufficiently suppressed is the exposure of a substrate to an atmosphere at a high temperature of about 1000 °C in a transistor fabrication process such as an activation process of impurities implanted in source/drain regions. It is considered that, as a result of the exposure, polysilicon is crystallized and the crystal boundary thereof serves as a leakage path.

In addition, it has been reported that the high-temperature thermal process undesirably causes a reaction between the material of the gate electrode and the material of the gate insulating film and consequently changes the effective work function of the gate electrode material. This phenomenon is termed a Fermi-level pinning phenomenon. For example, it has been reported that, when polysilicon is used as the gate electrode material, the effective work function of polysilicon is fixed to a value slightly closer to that of n⁺ polysilicon than to the mid-gap (middle value of the band gap energy) of silicon independently of the type of a dopant of polysilicon and, consequently, the absolute value of the threshold voltage of a p-type FET considerably increases (see Hobbs et al., IEEE transactions on electron devices, 2004, Vo. 51, pp.971-977). When the threshold voltage of a MOS transistor increases, a sufficient drain current cannot be obtained. As a result, even when the gate capacitance thereof is increased, the transistor cannot be operated at a high speed.

Therefore, in place of the partially silicided polysilicon electrode, a metal gate electrode using a film made of a metal or a compound having a metallic conductivity and a fully-silicided gate electrode using a polysilicon film that has been fully silicided to the interface with a gate insulating film have been proposed (see, e.g., Japanese Laid-Open Patent Publication No. 2005-243678).

Although the background in which the metal gate electrode or the fully-silicided gate electrode is used when the gate insulating film is made of a high dielectric constant material has been mentioned above, even when a gate insulating film is made of SiO₂, the merit of allowing the suppression of the depletion of a gate electrode is offered by using a metal gate electrode or a fully-silicided gate electrode. That is, in the operation of a transistor, the depletion of a polysilicon gate electrode which occurs when the channel polarity is inverted reduces the effective gate capacitance thereof. Therefore, by using the metal gate electrode or the fully-silicided gate electrode, it becomes possible to suppress the reduction in gate capacitance and obtain a larger current driving force.

However, the metal gate electrode formed by depositing the metal film or the compound film having a metallic conductivity has the problem that electrode formation in a p-channel MOS transistor is difficult. In an n-channel MOS transistor, on the other hand, the metal gate electrode can be formed by depositing a film made of titanium nitride (TaN), tantalum silicon nitride (TaSiN), or the like in terms of work function values. In the case of using TaN or the like, the merits of allowing a change in the intrinsic work function of TaN through a change in the amount of nitrogen and allowing the adjustment of the threshold voltage are also offered. As a result, the selection of a material for the metal gate electrode is relatively easy when the metal gate electrode is formed in the n-channel MOS transistor.

By contrast, the p-channel MOS transistor needs a large function, unlike the n-channel MOS transistor. Accordingly, for the p-channel MOS transistor, it is necessary to form the metal gate electrode by using a film made of a material containing a precious metal group including platinum (Pt), ruthenium (Ru), iridium (Ir), or the like. Because the film made of such a material containing a precious metal group has a large stress between itself and a gate insulating film, it has the problem that the formed electrode is likely to peel off. In addition, the film made of a material containing a precious metal group also has a problem associated with microfabrication because it is made of a material difficult to etch and the patterning thereof into the configuration of the gate electrode after film deposition is also difficult.

Moreover, in a complementary metal oxide film semiconductor (CMOS) process in which an n-channel MOS transistor and a p-channel MOS transistor are embedded in a single substrate, it is necessary to form two types of metal gate electrodes by individually depositing two types of metal films or compound films having different work functions and individually patterning the metal films or compound films. As a result, another problem is encountered that the fabrication process steps are more complicated than those for a conventional polysilicon electrode.

On the other hand, the fully-silicided gate electrode formed by successively depositing the polysilicon film and a meal film made of nickel (Ni) or the like and then performing a thermal process to completely silicide a polysilicon electrode can be more easily formed than the metal gate electrode formed by directly depositing the metal film. However, as described above, the n-channel MOS transistor and the p-channel MOS transistor have different work functions that are optimal for gate electrodes. The work function of a fully-silicided gate electrode is determined by a composition ratio between Ni and Si. The composition ratio between Ni and Si after silicidation is determined by conditions for the thermal process during silicidation. As a result, a problem is encountered that it is extremely difficult to form the fully-silicided gate electrodes having different work functions in a single substrate.

### SUMMARY OF THE INVENTION

It is therefore an object of the present invention to solve the conventional problems described above and implement a semiconductor device wherein an n-channel MOS transistor and a p-channel MOS transistor, each having a low leakage current and a low threshold voltage, are formed in a single substrate.

To attain the object, the present invention constructs a semiconductor device comprising a metal gate electrode and a fully-silicided gate electrode.

Specifically, a semiconductor device according to the present invention comprises: a transistor of a first conductivity formed on a semiconductor substrate and having a first gate insulating film and a first gate electrode; and a transistor of a second conductivity type formed on a different region of the semiconductor substrate from a region thereof on which the transistor of the first conductivity is formed and having a second gate insulating film and a second gate electrode, wherein the first gate electrode is a metal gate electrode having a metal film and the second gate electrode is a fully-silicided gate electrode.

The semiconductor device according to the present invention allows easy individual formation of the first and second gate electrodes having different work functions. Therefore, it is possible to easily form a gate electrode having the work function optimal for an n-channel MOS transistor as the first gate electrode and form a gate electrode having the work function optimal for a p-channel MOS transistor as the second gate electrode. As a result, a semiconductor device in which each of the n-channel MOS transistor and the p-channel MOS transistor has a reduced leakage current and a low threshold voltage can be implemented.

In the semiconductor device according to the present invention, at least one of the first gate insulating film and the second gate insulating film is preferably made of a high dielectric constant material.

In this case, the high dielectric constant material preferably contains at least one of silicon, hafnium, zirconium, titanium, tantalum, aluminum, and a rare earth metal.

In the semiconductor device according to the present invention, the transistor of the first conductivity type is preferably an n-channel MOS transistor and the transistor of the second conductivity type is preferably a p-channel MOS transistor. The arrangement allows the formation of gate electrodes which are individually optimal for the n-channel MOS transistor and the p-channel MOS transistor without using a material containing a precious metal group which is likely to cause the peeling off of the gate electrode from the gate insulating film and difficult to process.

In the semiconductor device according to the present invention, the metal film is preferably a single-layer film made of a material selected from the group consisting of Ta, TaN, TaSi, TaSiN, TaAl, TaAlN, TaAlSi, TaAlSiN, TaC, and TaCN or a multilayer film made of at least two materials selected from the group consisting of Ta, TaN, TaSi, TaSiN, TaAl, TaAlN, TaAlSi, TaAlSiN, TaC, and TaCN. The arrangement allows reliable reductions in the leakage current and threshold voltage of the n-channel MOS transistor. The arrangement also allows easy formation of the first gate electrode.

In this case, the metal gate electrode preferably has a silicide film formed on the metal film. The arrangement provides easy connection between the gate electrode and a contact plug and also allows a reduction in the resistance value of the gate electrode.

In the semiconductor device according to the present invention, the first gate insulating film preferably has a thickness larger than a thickness of the second gate insulating film. The arrangement allows compensation for an increase in the gate leakage current of the n-channel MOS transistor due to a silicon dioxide film generated at the interface between the substrate made of silicon and the high dielectric constant film and allows the respective gate leakage currents of the n-channel MOS transistor and the p-channel MOS transistor to have equal characteristics.

In the semiconductor device according to the present invention, the fully-silicided gate electrode is preferably made of a silicide containing any one of Ni, Pt, and Co.

A method for fabricating a semiconductor device according to the present invention comprises the steps of: (a) forming a first insulating film on a semiconductor substrate and then forming a metal film on the formed first insulating film; (b) removing respective portions of the first insulating film and the metal film which are located in a region of the semiconductor substrate to expose an upper surface of the semiconductor substrate; (c) forming a second insulating film on the exposed portion of the semiconductor substrate; (d) forming a polysilicon film over the metal film and the second insulating film; (e) patterning the polysilicon film formed on the metal film and the metal film to form a first gate electrode which is a metal gate electrode and patterning the polysilicon film formed on the second insulating film to form a second gate electrode; and (f) siliciding the patterned polysilicon film to change the second gate electrode into a fully-silicided gate electrode.

The method for fabricating a semiconductor device according to the present invention allows easy individual formation of the metal gate electrode and the fully-silicided gate electrode without complicating the process steps. Because the first and second insulating films are formed individually, the respective gate insulating films of the n-channel MOS transistor and the p-channel MOS transistor can be easily formed to have different thicknesses.

In the method for fabricating a semiconductor device according to the present invention, the step (c) preferably includes the sub-steps of: forming the second insulating film over the exposed portion of the semiconductor substrate and the metal film; and removing the portion of the second insulating film which is formed on the metal film.

Preferably, the method for fabricating a semiconductor device according to the present invention further comprises the step of: (g) after the step (e) and before the step (f), forming sidewalls on respective side surfaces of the first gate electrode and the second gate electrode.

Preferably, the method for fabricating a semiconductor device according to the present invention further comprises the step of: (h) after the step (g) and before the step (f), forming source/drain regions of a first conductivity type in respective portions of the semiconductor substrate which are located on both sides of the first gate electrode and forming source/drain regions of a second conductivity type in respective portions of the semiconductor substrate which are located on both sides of the second gate electrode; (i) after the step (h) and before the step (f), siliciding the source/drain regions of the first conductivity type and the source/drain regions of the second conductivity type; (j) after the step (d) and before the step (i), forming a third insulating film on the polysilicon film; and (k) after the step (j) and before the step (f), removing the third insulating film.

### BRIEF DESCRIPTION OF THE DRAWINGS

FIG. **1** is a cross-sectional view of a semiconductor device according to an embodiment of the present invention;
FIGS. **2A** to **2C** are cross-sectional views illustrating a method for fabricating a semiconductor device according to the embodiment of the present invention in the order in which the process steps thereof are performed;
FIGS. **3A** to **3C** are cross-sectional views illustrating the method for fabricating the semiconductor device according to the embodiment of the present invention in the order in which the process steps thereof are performed;
FIGS. **4A** to **4C** are cross-sectional views illustrating the method for fabricating the semiconductor device according to the embodiment of the present invention in the order in which the process steps thereof are performed;
FIGS. **5A** to **5C** are cross-sectional views illustrating the method for fabricating the semiconductor device according to the embodiment of the present invention in the order in which the process steps thereof are performed; and
FIGS. **6A** to **6C** are cross-sectional views illustrating the method for fabricating the semiconductor device according to the embodiment of the present invention in the order in which the process steps thereof are performed.

### DETAILED DESCRIPTION OF THE INVENTION

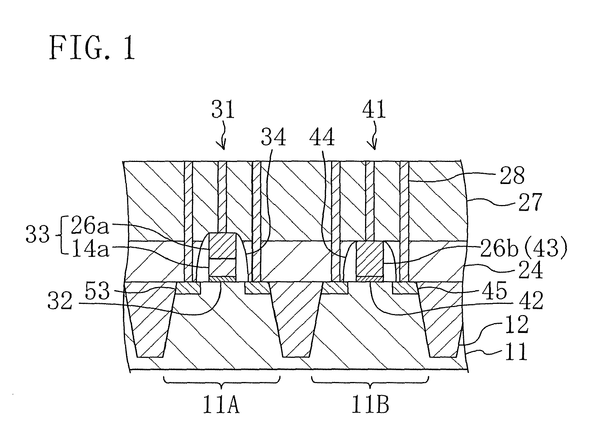

An embodiment of the present invention will be described with reference to the drawings. FIG. **1** shows a cross-sectional structure of a semiconductor device according to the embodiment of the present invention. As shown in FIG. **1,** the semiconductor device according to the present embodiment comprises a p-channel MOS transistor and an n-channel MOS transistor which are formed on a substrate.

In a substrate **11** made of silicon, a first region **11A** and a second region **11B** which are isolated from each other by an isolation region **12** are formed. An n-channel MOS transistor **31** is formed in the first region **11A.**

The n-channel MOS transistor **31** has a first gate insulating film **32** made of hafnium dioxide (HfO₂) formed on the substrate **11** and a first gate electrode **33** comprising sidewalls **34.** In the portions of the first region **11A** which are located on both sides of the first gate electrode **33,** n-type source/drain regions **35** are formed individually. The first gate electrode **33** in the semiconductor device according to the present embodiment is a metal gate electrode comprised of a metal film **14a** made of TaN and a silicide film **26a** made of platinum silicide which are successively stacked in layers in an ascending order, in which the metal film **14a** is formed in contact with the first gate insulating film **32.** In the present embodiment, the metal gate electrode is defined as a gate electrode formed such that a film made of a metal or a metal compound having a metallic conductivity is deposited in contact with a gate insulating film. It is assumed that the metal film in the metal gate electrode includes not only a film made of a metal but also a film made of a metal compound having a metallic conductivity.

A p-channel MOS transistor **41** has a second gate insulating film **42** made of HfO₂ formed on the substrate **11** and a second gate electrode **43** comprising sidewalls **44.** In the portions of the second region **11B** which are located on both sides of the second gate electrode **43,** p-type source/drain regions **45** are formed individually. The second gate electrode **43** is a fully-silicided gate electrode in which a silicide film **26b** is formed on the second gate insulating film **42.** The fully-silicided gate is a gate electrode formed by depositing a polysilicon film on a gate insulating film and then completely siliciding the deposited polysilicon film to the interface with the gate insulating film.

The n-channel MOS transistor **31** and the p-channel MOS transistor **41** are covered with interlayer insulating films **24** and **27** formed in succession. In the interlayer insulating films **24** and **27,** contact plugs **28** electrically connected individually to the first gate electrode **33,** the n-type source/drain regions **35,** the second gate electrode **43,** and the p-type source/drain regions **45** are formed.

In the semiconductor device according to the present embodiment, the n-channel MOS transistor **31** has the first gate electrode **33** which is the metal gate electrode made of TaN and the p-channel MOS transistor **41** has the second gate electrode **43** which is the fully-silicided gate electrode. Thus, the gate electrodes having different work functions are formed individually in the n-channel MOS transistor **31** and the p-channel MOS transistor **41.** As a result, in either of the n-channel MOS transistor **31** and the p-channel MOS transistor **41,** a leakage current and a threshold voltage can be reduced.

In the semiconductor device according to the present embodiment, the fully-silicided gate electrode is formed in the p-channel MOS transistor **41.** As a result, the peeling off of the gate electrode from the gate insulating film can be suppressed more reliably than in the case where a metal gate electrode using platinum (Pt) or the like is formed. In addition, the gate electrode can be formed more easily than in the case where the metal gate electrode is formed by etching Pt or the like.

Unlike in the case where the fully-silicided gate electrode is formed in each of the n-channel MOS transistor **31** and the p-channel MOS transistor **41,** full silicidation can be performed under conditions which are optimal for the p-channel MOS transistor **41.**

Instead of the HfO₂ film, a high dielectric constant film such as a hafnium silicate (HfSiO) film or a hafnium silicon oxynitride (HfSiON) film can be used as each of the first and second gate insulating films **32** and **42.** Instead, a high dielectric constant film made of a material containing at least one of silicon (Si), hafnium (Hf), zirconium (Zr), titanium (Ti), tantalum (Ta), aluminum (Al), and rare earth metals such as scandium (Sc), yttrium (Y), lantern (La), and other lanthanoids may also be used. The first and second gate insulating films **32** and **43** may also be formed of different materials. Instead of the high dielectric constant film, a SiO₂ film may also be used. In this case also, the merit of allowing the prevention of the depletion of the first gate electrode **33** and allowing the obtention of a transistor with a large driving current is offered.

The metal film **14a** of the first gate electrode **33** may also be made of, instead of TaN, a material selected from the group consisting of tantalum (Ta), tantalum silicon (TaSi), tantalum silicon nitride (TaSiN), tantalum aluminum (TaAl), tantalum aluminum nitride (TaAIN), tantalum aluminum silicon (TaAlSi), tantalum aluminum silicon nitride (TaAlSiN), tantalum carbide (TaC), tantalum carbide nitride (TaCN), and the like. The metal film **14a** may also be a multilayer film made of at least two materials selected from the group listed above. In this case, the work function is preferably adjusted to be not less than 4.2 eV and not more than 4.5 eV. In the case where the metal film **14a** is made of a nitride, the composition of nitrogen is preferably not more than 50%.

The second gate electrode **43** may be made of, instead of platinum silicide, any of nickel silicide, cobalt silicide, and the like.

Although the semiconductor device according to the present embodiment has formed the first gate electrode **33** by using a multilayer film of the metal film **14a** and the silicide film **26a** to provide easy connection between the contact plug **28** and the first gate electrode **33** and reduce the resistance value of the first gate electrode **33,** it is also possible to form the first gate electrode **33** by using only the metal film **14a** without providing the silicide film **26a.**

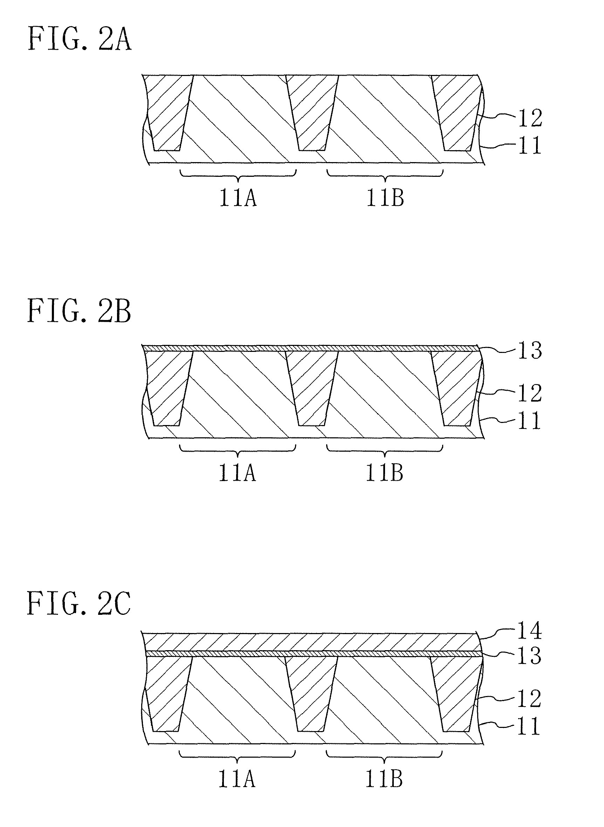

Referring to the drawings, a method for fabricating the semiconductor device according to the present embodiment will be described herein below. FIGS. **2A** to **6C** illustrate the fabrication method for the semiconductor device according to the present embodiment in the order in which the process steps thereof are performed.

First, as shown in FIG. **2A,** the trench isolation region **12** is formed in the substrate **11** made of silicon so that the first region **11A** in which the n-channel MOS transistor **31** is formed and the second region **11B** in which the p-channel MOS transistor **41** is formed are formed. The isolation region may also be formed by using a localoxidation of silicon (LOCOS) technology.

Next, as shown in FIG. **2B,** a native oxide film formed on the upper surface of the substrate **11** is removed by using a diluted aqueous fluoric acid solution. Then, a first insulating film **13** made of HfO₂ or the like and serving as the first gate insulating film **32** is formed on the substrate **11.**

The formation of the HfO₂ film may be performed appropriately by depositing a metal film made of Hf or the like by using a DC sputtering method or the like and then oxidizing the metal film. The method for depositing the metal film may also be a physical vapor deposition (PVD) method, a vacuum vapor deposition method, an electron beam deposition method, a laser deposition method, a chemical vapor deposition (CVD) method, a metal organic vapor deposition method, an atomic layer deposition method, or the like. Instead of the metal oxide film, there may also be formed a metal silicate film such as HfSiO₄ film, a metal nitride-silicate film such as a HfSiON film, or the like. After the removal of the native oxide film, it is also possible to form an oxide film, a nitride film, or the like on the upper surface of the substrate **11** as necessary.

Next, as shown in FIG. **2C,** a metal film **14** made of TaN or the like is formed by using a sputtering method or the like on the first insulating film **13.** In the case where the metal film **14** is made of TaN, the TaN film may be formed appropriately by sputtering a Ta target in an argon-nitrogen atmosphere under a pressure of 0.4 kPa. Ta atoms sputtered out of the Ta target adhere onto the first insulating film **13** and then react with nitrogen in the atmosphere, thereby forming the TaN film.

Likewise, when the metal film **14** is made of TaSi, TaAl, TaAlSi, TaC, or the like, the film may be formed appropriately by sputtering the corresponding metal target in an argon atmosphere or in a gas mixture of argon and nitrogen.

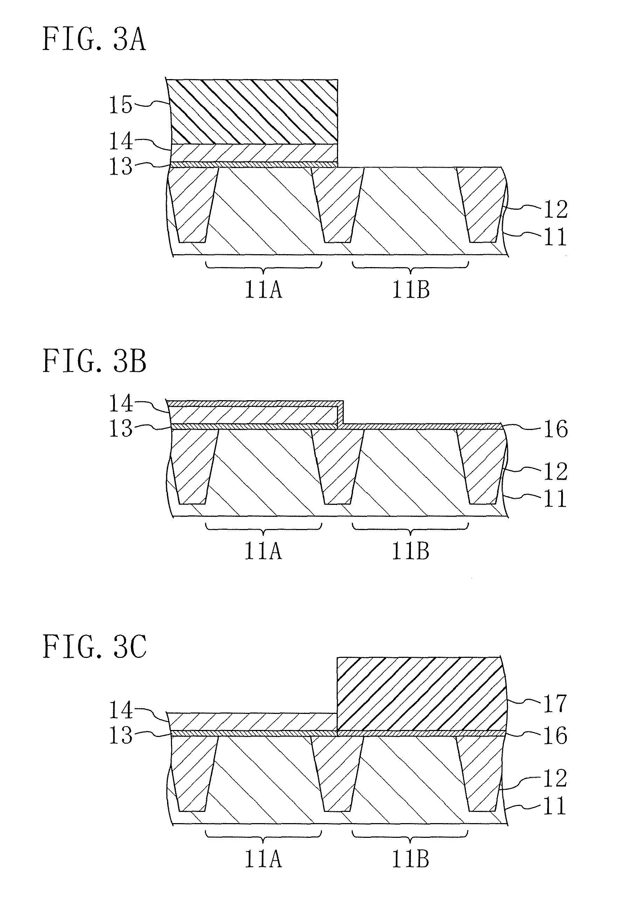

Next, as shown in FIG. **3A,** a resist mask **15** for exposing the second region **11B** is formed on the metal film **14** by using a photolithographic technology. Then, the respective portions of the metal film **14** and the first insulating film **13** which are formed on the second region **11B** are etched so that the upper surface of the substrate **11** is exposed in the second region **11B.** For the etching, a solution mixture of a fluoric acid and a nitric acid may be used appropriately as an etchant. Instead of wet etching, dry etching may also be used.

Next, as shown in FIG. **3B,** a second insulating film **16** is deposited over the upper surface of the metal film **14** and the exposed upper surface of the substrate **11.** For the second insulating film **16,** a high dielectric constant film made of HfO₂, HfSiO, HfSiON, or the like may be formed appropriately in the same manner as for the first insulating film **13.** The second insulating film **16** may be made of a material which is the same as or different from the material of the first insulating film **13.** As each of the first and second insulating films **13** and **16,** a silicon oxide film may also be formed instead of the high dielectric constant film.

The thickness of the second insulating film **16** may be the same as that of the first insulating film **13.** However, as will be described later, the thickness of the first insulating film **13** is preferably adjusted to be larger than that of the second insulating film **16.**

Next, as shown in FIG. **3C,** a resist mask **17** for exposing the first region **11A** is formed by using a photolithographic technology. Then, the portion of the second insulating film **16** which is formed on the metal film **14** is removed. The removal of the portion of the second insulating film **16** may be performed appropriately by wet etching using, e.g., a diluted fluoric acid as an etchant. When a protective film made of polysilicon is formed on the second insulating film **16,** wet etching may be performed appropriately by using a diluted fluoric acid after the protective film is removed first by using an APM solution (a solution mixture of ammonia, aqueous hydrogen peroxide, and water). Instead of wet etching, dry etching may also be used.

The present embodiment has removed the first insulating film **13** and the metal film **14** from the second region **11B** in order to prevent the degradation of the quality of the gate insulating film of the p-channel MOS transistor **41.** However, it is also possible to leave the first insulating film **13** as it is in the second region **11B** and use it as a replacement for the second insulating film **16.** In this case, the merit of allowing the omission of the step of forming the second insulating film **16** and thereby allowing the simplification of the steps is offered.

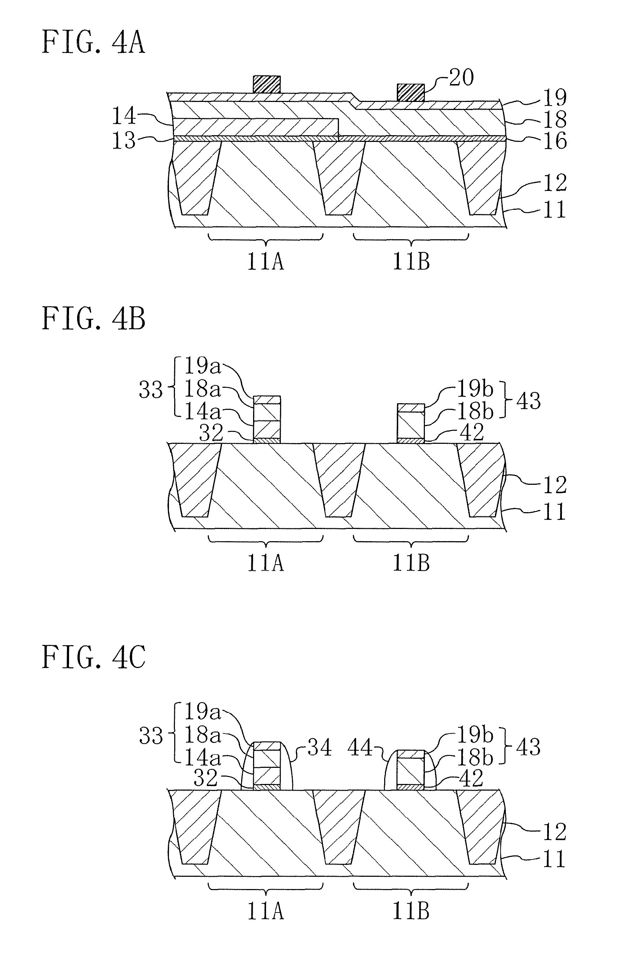

Next, as shown in FIG. **4A,** a polysilicon film **18** and a third insulating film **19** made of SiO₂ or the like are deposited over the respective upper surfaces of the metal film **14** and the second insulating film **16.** The deposition of the polysilicon film **18** may be performed appropriately by a CVD method using a silane gas. The deposition of the third insulating film **19** may be performed appropriately by a plasma CVD method using tetraethoxysilane (TEOS). The third insulating film **19** is a protective film in the silicidation of the source/drain regions, which will be described later, and may be formed appropriately as necessary. Subsequently, a resist mask **20** is formed on each of portions serving as the first and second gate electrodes **33** and **43.**

Next, as shown in FIG. **4B,** the third insulating film **19,** the polysilicon film **18,** the metal film **14,** the first insulating film **13,** and the second insulating film **16** are selectively removed by dry etching so that the first gate electrode **33** comprised of the metal film **14a,** a polysilicon film **18a,** and a third insulating film **19a** and the second gate electrode **43** made of a polysilicon film **18b** and a third insulating film **19b** are formed. Thereafter, an n-type impurity is implanted into the first region **11A** and a p-type impurity is implanted into the second region **11B,** each by using an ion implantation technology, so that extension regions (not shown) are formed individually.

Next, as shown in FIG. **4C,** a SiN film is deposited over the entire surface of the substrate **11** and then subjected to anisotropic etching so that the sidewalls **34** and the sidewalls **44** are formed on the respective side surfaces of the first and second gate electrodes **33** and **43.**

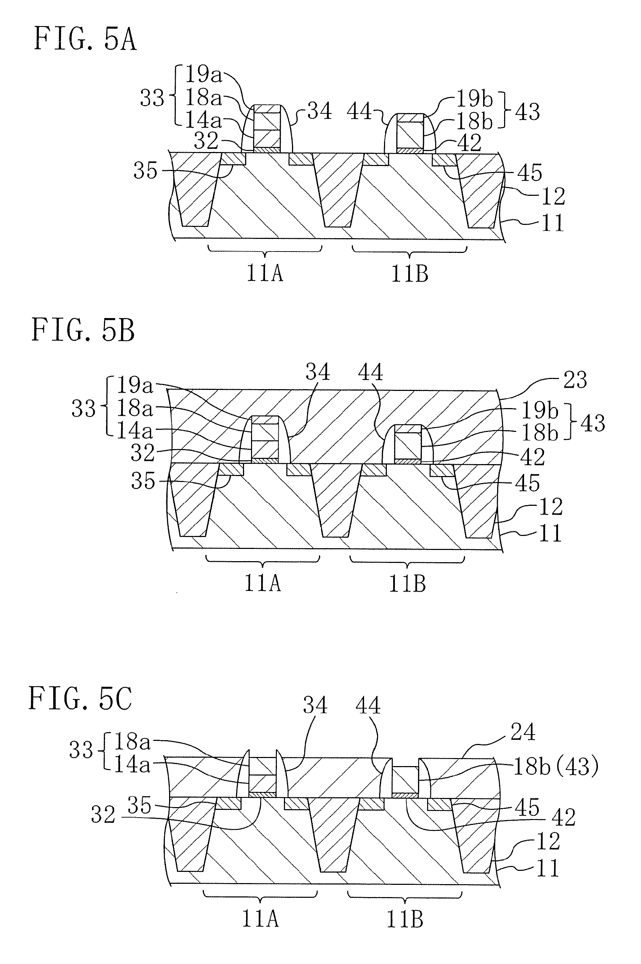

Next, as shown in FIG. **5A,** an n-type impurity is implanted into the first region **11A** and a p-type impurity is implanted into the second region **11B** and a thermal process is performed at 1000 °C for 3 seconds, thereby individually forming the n-type source/drain regions **35** and the p-type source/drain regions **45.**

Subsequently, a metal film **23** made of nickel is deposited over the entire surface of the substrate **11** and then subjected to a thermal process at a temperature of 500 °C so that the n-type source/drain regions **35** and the p-type source/drain regions **45** are silicided. Since the polysilicon film **18a** of the first gate electrode **33** and the polysilicon film **18b** of the second gate electrode **43** are protected by the third insulating films **19a** and **19b,** respectively, they are not silicided. For the metal film **23,** platinum, cobalt, or the like may also be used.

Next, as shown in FIG. **5B,** the unreacted portion of the metal film **23** is removed by using a SPM solution (a solution mixture of a sulfuric acid, aqueous hydrogen peroxide, and water). Thereafter, an interlayer insulating film **24** is deposited over the entire surface of the substrate **11.** Subsequently, the interlayer insulating film **24** is polished by using a CMP technology till the third insulating film **19a** of the first gate electrode **33** and the third insulating film **19b** of the second gate electrode **43** are exposed.

Next, as shown in FIG. **5C,** the third insulating films **19a** and **19b** are removed by using a chemical solution containing a fluoric acid so that the polysilicon film **18a** of the first gate electrode **33** and the polysilicon film **18b** of the second gate electrode **43** are exposed.

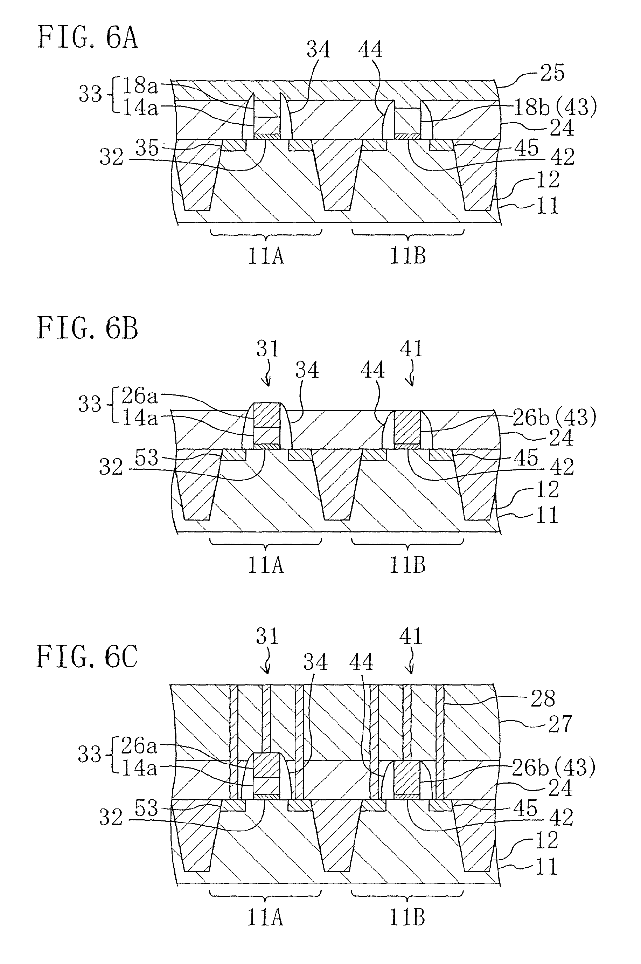

Next, as shown in FIG. **6A,** a metal film **25** made of platinum is deposited by a sputtering method or the like over the entire surface of the substrate **11.** As the deposition method, CVD, vapor deposition, laser abrasion, or the like may also be used. Instead of platinum, there may also be deposited nickel, cobalt, or the like.

Next, as shown in FIG. **6B,** a thermal process is performed at a temperature of not more than 500 °C, thereby individually changing the polysilicon film **18a** of the first gate electrode **33** and the polysilicon film **18b** of the second gate electrode **43** into the silicide films **26a** and **26b** each made of platinum silicide. In this case, in the p-channel MOS transistor **41,** a stress in a direction of compression is applied to the second gate insulating film **42** as a result of volume expansion when the polysilicon film **18b** is changed into the silicide film **26b.** Since the mobility of hole carriers is normally improved by the compressive stress, the characteristics of a drain current in the p-channel MOS transistor **41** are improved. In the n-channel MOS transistor **31,** on the other hand, when the stress in the direction of compression is applied to the first gate insulating film **32,** the characteristics are degraded conversely to the case where the stress is applied in the p-channel MOS transistor. However, since the metal film **14a** is present between the silicide film **26a** and the first gate insulating film **32** in the n-channel MOS transistor **31,** the effect of the stress is suppressed and the degradation of the characteristics thereof is limited.

Next, as shown in FIG. **6C,** the unreacted portion of the metal film **25** is removed by using a SPM solution. Then, an interlayer insulating film **27** is deposited to form the contact plugs **28** electrically connected individually to the n-type source/drain regions **35,** the p-type source/drain regions **45,** the first gate electrode **33,** and the second gate electrode **43,** each of which has been silicided.

When a high dielectric constant material is used for a gate insulating film, a SiO₂ film is relatively easily formed at the interface between silicon and the high dielectric constant film so that the gate insulating film has a multilayer structure of the thin SiO₂ film and the high dielectric constant film. The upper-layer dielectric film has a small band gap and a large thickness, while the lower-layer SiO₂ film has a large band gap and a small thickness. In the gate insulating film having such an asymmetrical band structure, the magnitude of a leakage current differs depending on the direction of carrier injection. Therefore, it follows that, in an n-channel MOS transistor and a p-channel MOS transistor, the leakage currents have different characteristics.

In the n-channel MOS transistor, electrons supplied from the source/drain regions are introduced from the channel side so that the leakage current is primarily determined by the thickness of the SiO₂ film in contact with the channel. Since the SiO₂ film is normally thinner than the high dielectric constant film, the leakage current is large and larger than in the p-channel MOS transistor. Accordingly, to suppress the leakage current in the n-channel MOS transistor, it is required to form the gate insulating film made of a high dielectric constant material such that it is thicker than in the p-channel MOS transistor.

In the present embodiment, the first gate insulating film **32** of the n-channel MOS transistor **31** and the second gate insulating film **42** of the p-channel MOS transistor **41** are formed by different process steps. This allows easy formation the first gate insulating film **32** which is thicker than the second gate insulating film **42** and therefore allows the respective leakage currents of the n-channel MOS transistor **31** and the p-channel MOS transistor **41** to have equal characteristics.

Thus, the semiconductor device according to the present invention and the fabrication method therefor can implement a semiconductor device in which an n-channel MOS transistor and a p-channel MOS transistor, each of which has a low leakage current and a low threshold voltage, are formed in a single substrate and are therefore useful as a semiconductor device comprising an n-channel MOS transistor and a p-channel MOS transistor, a fabrication method therefor, and the like.

## Claims

1. A semiconductor device comprising:
a transistor of a first conductivity formed on a semiconductor substrate and having a first gate insulating film and a first gate electrode; and
a transistor of a second conductivity type formed on a different region of the semiconductor substrate from a region thereof on which the transistor of the first conductivity is formed and having a second gate insulating film and a second gate electrode, wherein
the first gate electrode is a metal gate electrode having a metal film and
the second gate electrode is a fully-silicided gate electrode.

2. The semiconductor device of claim 1, wherein at least one of the first gate insulating film and the second gate insulating film is made of a high dielectric constant material.

3. The semiconductor device of claim 2, wherein the high dielectric constant material contains at least one of silicon, hafnium, zirconium, titanium, tantalum, aluminum, and a rare earth metal.

4. The semiconductor device of claim 1, wherein the transistor of the first conductivity type is an n-channel MOS transistor and the transistor of the second conductivity type is a p-channel MOS transistor.

5. The semiconductor device of claim 4, wherein the metal film is a single-layer film made of a material selected from the group consisting of Ta, TaN, TaSi, TaSiN, TaAl, TaAlN, TaAlSi, TaAlSiN, TaC, and TaCN or a multilayer film made of at least two materials selected from the group consisting of Ta, TaN, TaSi, TaSiN, TaAl, TaAlN, TaAlSi, TaAlSiN, TaC, and TaCN.

6. The semiconductor device of claim 5, wherein the metal gate electrode has a silicide film formed on the metal film.

7. The semiconductor device of claim 4, wherein the first gate insulating film has a thickness larger than a thickness of the second gate insulating film.

8. The semiconductor device of claim 1, wherein the fully-silicided gate electrode is made of a silicide containing any one ofNi, Pt, and Co.

9. A method for fabricating a semiconductor device, the method comprising the steps of:
(a) forming a first insulating film on a semiconductor substrate and then forming a metal film on the formed first insulating film;
(b) removing respective portions of the first insulating film and the metal film which are located in a region of the semiconductor substrate to expose an upper surface of the semiconductor substrate;
(c) forming a second insulating film on the exposed portion of the semiconductor substrate;
(d) forming a polysilicon film over the metal film and the second insulating film;
(e) patterning the polysilicon film formed on the metal film and the metal film to form a first gate electrode which is a metal gate electrode and patterning the polysilicon film formed on the second insulating film to form a second gate electrode; and
(f) siliciding the patterned polysilicon film to change the second gate electrode into a fully-silicided gate electrode.

10. The method of claim 9, wherein the step (c) includes the sub-steps of:
forming the second insulating film over the exposed portion of the semiconductor substrate and the metal film; and
removing the portion of the second insulating film which is formed on the metal film.

11. The method of claim 9, further comprising the step of:
(g) after the step (e) and before the step (f), forming sidewalls on respective side surfaces of the first gate electrode and the second gate electrode.

12. The method of claim 11, further comprising the steps of:
(h) after the step (g) and before the step (f), forming source/drain regions of a first conductivity type in respective portions of the semiconductor substrate which are located on both sides of the first gate electrode and forming source/drain regions of a second conductivity type in respective portions of the semiconductor substrate which are located on both sides of the second gate electrode;
(i) after the step (h) and before the step (f), siliciding the source/drain regions of the first conductivity type and the source/drain regions of the second conductivity type;
(j) after the step (d) and before the step (i), forming a third insulating film on the polysilicon film; and
(k) after the step (j) and before the step (f), removing the third insulating film.
